Europäisches Patentamt

European Patent Office

Office européen des brevets

(19)

(11) Publication number: **0 054 561**
**B1**

(12) **EUROPEAN PATENT SPECIFICATION**

(45) Date of publication of patent specification: **16.04.86**

(21) Application number: **81901781.5**

(22) Date of filing: **21.05.81**

(86) International application number:
**PCT/US81/00726**

(87) International publication number:
**WO 81/03589 10.12.81 Gazette 91/29**

(51) Int. Cl.⁴: **H 03 K 4/02, H 03 K 5/156,**
**H 03 K 6/00, H 03 K 17/16,**
**H 03 K 17/687, G 06 G 7/186**

(54) SWITCHED-CAPACITOR INTERPOLATION FILTER.

(30) Priority: **29.05.80 US 154574**

(43) Date of publication of application:
**30.06.82 Bulletin 82/26**

(45) Publication of the grant of the patent:
**16.04.86 Bulletin 86/16**

(84) Designated Contracting States:
**DE FR GB NL SE**

(56) References cited:
**US-A-3 676 784**
**US-A-4 179 665**
**US-A-4 210 872**

**IEEE TRANSACTIONS ON CIRCUITS &
SYSTEMS, vol. CAS-27, no. 6, June 1980 NEW
YORK (US) R. GREGORIAN et al.: "Switched-
Capacitor Decimation and Interpolation
Circuits", pages 509-514**

**N, IEEE JOURNAL OF SOLID STATE CIRCUITS,
VOL. SC12, No. 6 ISSUED DECEMBER 1977 pp
592-599, "SAMPLED ANALOG FILTERING
USING SWITCHED CAPACITORS AS RESISTOR
EQUIVALENTS" BY CAVES ET AL. SEE FIG.4**

(73) Proprietor: **AMERICAN MICROSYSTEMS,
INCORPORATED**
**3800 Homestead Road**
**Santa Clara, CA 95051 (US)**
(73) Proprietor: **HITACHI, LIMITED**
**World Trade Center Building No. 4-1, 2-chome**
**Hamamatsu-cho**
**Minato-ku Tokyo 105 (JP)**

(72) Inventor: **GREGORIAN, Roubik**
**2382 Shoreside Court**
**Santa Clara, CA 95050 (US)**
Inventor: **SUZUKI, Toshiro**
**D-206 Hitachi Apt. 2-32 Koyasu**
**Hachioji 192 (JP)**

(74) Representative: **Mitscherlich, Hans, Dipl.-Ing.
et al**
**Patentanwälte Dipl.-Ing. H. Mitscherlich Dipl.-
Ing. K. Gunschmann Dipl.-Ing. Dr.rer.nat. W.
Körber Dipl.-Ing. J. Schmidt-Evers Dipl.-Ing. W.
Melzer Steinsdorfstrasse 10**
**D-8000 München 22 (DE)**

## Description

This invention relates to a circuit for receiving a sampled input signal and producing an output according to the preamble portion of claim 1, in brief to a switched-capacitor interpolation filter.

Such a switched-capacitor type interpolation filter is shown in IEEE Journal of Solid State Circuits, vol. SC12 (Dec. 1977) No. 6, p 592 to 599, "Sampled Analog Filtering Using Switched Capacitors as Resistor Equivalents" (by Caves et al.). Further switched-capacitor elliptic filters are shown n US—A—4 179 655. In both known filters MOSFET-switches may be used and a second clock is in antiphase with a first clock, both clocks controlling said switches to charge and discharge capacitors to submit signals to the inverting input of an operational amplifier.

In a switched-capacitor filter of the type used in sampled-data circuits, the output signal is sampled and held at the clocking frequency. The frequency spectrum of the output signal ordinarily contains some extraneous components around the multiples of the sampling frequency. To get a smooth output, these components should be rejected. Heretofore, in order to eliminate the aforesaid undesired signal components, an off-chip analog smoothing filter was used in conjunction with a switched capacitor filter. However, this expedient added considerable complexity and size to the overall circuit as well as introducing other disadvantages. Another approach to the problem was to substantially increase the sampling rate for the main filter; but this resulted in a relatively high capacitor ratio spread and thus, a much larger silicon area for the filter, when the filter is implemented in integrated circuit form.

It is therefore one object of the present invention to provide a switched-capacitor interpolation filter that solves the problem of undesired frequency components without the disadvantages of prior expedients.

Another object of the invention is to provide a switched-capacitor interpolation filter capable of procuding an output signal which is sampled and held at twice the clocking frequency of the filter while maintaining the same capacitor ratio spread of a filter clocked at half the sampling rate.

In accordance with the present invention, as defined in the claims, an interpolation circuit is provided which transforms sampled-and-held signals from a switched capacitor filter into sampled-and-held signals with a doubled sample rate, thereby providing a smoothing function for the output signal. In effect, this circuit, by linear interpolation, removes the second replica (centered around the clocking frequency $f_c$ of the signal spectrum) and introduces an intermediate value between two adjacent steps of its input signal. In general, the circuit comprises an operational amplifier whose inverting input is connected to a switched capacitor network which receives sampled-and-held input signals from a filter at the normal sample rate. The network includes two separate capacitors controlled by switches operable at two alternating clock phases and connected to provide for the desired summation and holding of charges from the input signals. A feedback means containing additional capacitors is connected between the output of the operational amplifier and its inverting input. The circut produces the desired smoothing effect by producing an output signal that is sampled and held at twice the clocking frequency.

Fig. 1 is a circuit diagram of a switched-capacitor interpolation filter according to the invention.

Fig. 1a is a timing diagram for the clocks used in the circuit of Fig. 1;

Fig. 2 is a diagram showing a comparison of typical input and output voltages for the circuit of Fig. 1.

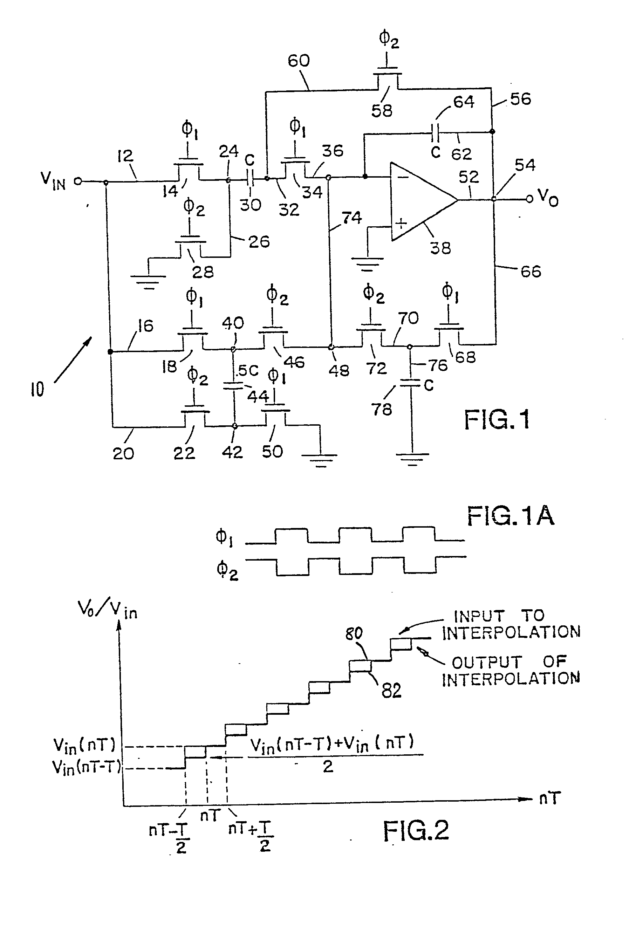

With reference to the drawing, Fig. 1 shows a circuit diagram for a switched capacitor interpolation filter circuit 10 according to the present invention. In a typical digital signal processing unit such as a coder-decoder (codec) the input lead 12 of this interpolation circuit 10 would be connected to the output lead of a switched-capacitor filter (not shown) whose output signal is sampled-and-held at the clocking frequency. The frequency spectrum of this output signal (shown as $V_{in}$ to circuit 10) normally contains extraneous signal components around multiples of the sampling frequency, and the interpolation filter circuit 10 must function to reject or eliminate the components around the sampling frequency to provide a smooth output signal $V_o$.

As shown, the input signal $V_{in}$ is provided in a lead 12 to one source/drain terminal of a first switch 14 which is preferably a metal-oxide-silicon field effect transistor (MOSFET). This same $V_{in}$ input signal is also supplied via a lead 16 to one source/drain terminal of a fourth MOSFET switch 18 and also via a lead 20 to one source/drain terminal of a sixth MOSFET switch 22.

The other source/drain terminal of first MOSFET switch 14 is connected to a junction 24 and its gate is connected to a first clock Ø1 with phase one. Junction 24 is connected via a lead 26 to one source/drain terminal of a third MOSFET switch 28 whose other source/drain terminal is connected to ground and whose gate is connected to a second clock Ø2 in antiphase with first clock Ø1, i.e. with phase two. Junction 24 is also connected to one side of a first capacitor 30 having capacitance value C whose other side is connected via a lead 32 to one source/drain terminal of a second MOSFET switch 34 whose other source/drain terminal is connected via a lead 36 to the inverting input of an operational amplifier 38. The noninverting input of this operational amplifier 38 is connected to ground.

The other source/drain terminal of fourth MOSFET switch 18 is connected to a junction 40 and the other source/drain terminal of sixth MOSFET switch 22 is connected to a junction 42, und these latter junctions 40, 42 are connected to opposite sides of a second capacitor 44, whose capacitance value is one half that of first capacitor 30 (i.e. 0.5C). The gate of fourth MOSFET switch 18 is connected to first clock Ø1 and the gate of sixth MOSFET switch 22 is connected to second clock Ø2.

Junction 40 is also connected to one source/drain terminal of a fifth MOSFET switch 46 whose other source/drain termiminal is connected to a junction 48, and junction 42 is also connected to one source/drain terminal of a seventh MOSFET switch 50 whose other source/drain terminal is connected to ground.

The output signal $(V_O)$ from operational amplifier 38 is provided in a lead 52 having a junction 54 from which extends a feedback lead 56 connected to one source/drain terminal of an eighth MOSFET switch 58 whose gate is connected to second clock Ø2. The other source/drain terminal of eighth MOSFET switch 58 is connected by a lead 60 to lead 32 between first capacitor 30 and second MOSFET switch 34. Connected between lead 56 and lead 36 is a feedback lead 62 containing a third capacitor 64 having capacitance value C that also receives output signal $V_O$.

Another feedback lead 66 extends from junction 54 to one source/drain terminal of a ninth MOSFET switch 68 whose other source/drain terminal is connected via a lead 70 to a source/drain terminal of a tenth MOSFET switch 72. Ninth and tenth MOSFET switches 68, 72 have gates connected to first clock Ø1 and second clock Ø2 respectively. The other source/drain terminal of tenth MOSFET switch 72 is connected to junction 48 which is connected to input lead 36 via a return lead 74. Extending from lead 70 between ninth and tenth MOSFET switches 68 and 72 is a lead 76 which is connected to one side of a fourth capacitor 78 of capacitance value C whose other side is connected to ground.

In operation of circuit 10, a sample-and-held input signal $V_{in}$, as received from a switched capacitor filter (not shown) is provided simultaneously on leads 12, 16 and 20. On first clock Ø1 (of phase one) the input signal is fed through the then closed first switch 14 to first capacitor 30 and becomes integrated on third capacitor 64. Fourth and seventh switches 18 and 50 also close, thus charging second capacitor 44 so that the voltage drop across second capacitor 44 becomes equal to the input signal $V_{in}$.

Also, on first clock Ø1 the output signal $V_O$ from operational amplifier 38, which is the negative of the input signal $V_{in}$ appears on fourth capacitor 78 through closed ninth switch 68. Now, on second clock Ø2, tenth switch 72 closes and ninth switch 68 opens and the charge on the top plate of fourth capacitor 78 is accumulated in third feedback capacitor 64. This effectively cancels the charge on third capacitor 64. At the same time, the bottom plate of second capacitor 44 is connected through closed sixth switch 22 to the new or next sample of the input signal $V_{in}$, and the top plate of second capacitor 14 is connected via closed fifth switch 46 to the inverting input of operational amplifier 38 so that the charge will also become integrated on third capacitor 64. That is, the voltage across third capacitor 64 will be equal to one-half the summation of the present and the previous value of the input signal voltage.

The smoothing function of circuit 10 is illustrated in Fig. 2 which shows a comparative diagram of simultaneous input and output signals for progressive clock cycles. As seen, the output signal $V_O$, instead of having a full step from the previous value of the negative input signal to the present value, has a step that is one half of that. When second clock Ø2 with phase two is on, the value of the output signal is charged on first capacitor 30 through eighth and third switches 58 and 28. Now, when the second clock Ø2 goes off and again first clock Ø1 with phase one comes, on, the left plate of first capacitor 30 is connected to the input signal $V_{in}$ and its charge is integrated by third capacitor 64. Thus, the charge on the right plate of first capacitor 30, which was equal to the previous value of the output signal times the capacitance C cancels the charge on third capacitor 64, und thus, at the end of first clock Ø1 the output signal $V_O$ is equal to the negative of the input signal $V_{in}$. Effectively what happens, as shown in Fig. 2, is that if the input signal is supplied so that the negative of the input signal has a "staircase" 80 in which the steps are repeated every first clock with phase one, the output signal has a "staircase" 82 with twice as many steps and the height of the height of the output steps is one half of the corresponding height of the input steps.

Apply the waveform definitions illustrated in Fig. 2, the input-output relation at t=nT (where t=time, n=number of samples, and T=sampling period) is:

$$V_O(nT) = -0.5[V_{in}(nT) + V_{in}(nT-T)].$$

Here, the relation

$$V_{in}(nT-T/2) = V_{in}(nT-T),$$

evident from Fig. 2, is utilized.

At $t_s nT+T/2$, $V_{in}(nT+T/2) = V_{in}(nT)$ holds, and hence, $V_O(nT+T/2) = -V_{in}(nT)$.

Fig. 2 shows that the desired input/output relations are realized and thus confirms that the circuit circuit 10 of Fig. 1 can be used as a sampling-rate-double filter.

**Claims**

1. A circuit for receiving a sampled input signal and producing an output signal, said circuit (10) including an input terminal for receiving said sampled input signal, an operational amplifier (38) having an inverting input, a noninverting input connected to ground and an output, a switched-capacitor input network (14, 30, 34; 22, 44, 46) connected between said inverting input and said input terminal, said network comprising a first and a second capacitor (30, 44), said second

capacitor (44) having a predetermined fractional capacitance of the said first capacitor (30),

a first switch means (14, 34) connecting said first capacitor (30) between said inverting input and said input terminal, a second switch means (22, 46) connecting said second capacitor (44) between said inverting input and said input terminal, a first clock (Ø1) and a second clock (Ø2) in antiphase with said first clock (Ø1) for controlling said first and said second switch means (14, 34, 22, 46) and feedback means (64, 68, 72, 78) connected between said output and said inverting input, said circuit (10) characterized in that:

said feedback means (64, 72, 78, 68) cooperates with said input network to provide a sampled output signal at double the input signal sampling frequency and every second input signal sample is equal to the negative of the input signal sample, and every other output signal sample is equal to a value interpolated from the negative values of two adjacent input signal samples.

2. A circuit according to claim 1, characterized in

a first switch (14) controlled by first clock (Ø1) and connecting one side of first capacitor (30) to said input terminal,

a second switch (34) controlled by first clock (Ø1) and connecting the other side of first capacitor (30) to said inverting input,

a third switch (28) controlled by second clock (Ø2) and connecting said one side of first capacitor (30) to ground,

a fourth switch (18) controlled by first clock (Ø1) and connecting one side of second capacitor (44) to said input terminal,

a fifth switch (46) controlled by second clock (Ø2) and connecting said one side of second capacitor (44) to said inverting input,

a sixth switch (22) controlled by second clock (Ø2) and connecting the other side of second capacitor (44) to said input terminal, and

a seventh switch (50) controlled by first clock (Ø1) and connecting said other side of second capacitor (44) to ground.

3. A circuit according to claim 1 or claim 2, characterized in that said feedback means comprises:

— a third capacitor (64) connected between said inverting input and said output terminal,

an eighth switch (58) controlled by second clock (Ø2) and connecting the other side of first capacitor (30) and said output

— a fourth capacitor (78), one side being connected to ground,

a ninth switch (68) controlled by first clock (Ø1) and connecting the other side of fourth capacitor (78) with said output,

a tenth switch (72) controlled by second clock (Ø2) and connecting said other side of fourth capacitor (78) with said inverting input.

4. A circuit according to any one of claims 1 to 3, characterized in that said first and if the case may be, third and fourth capacitor(s) (14, 58, 78) is/are of equal capacitance (C) twice the capacitance (0.5C) of said second capacitor (44).

5. A circuit according to any one of claims 1 to 4, characterized in that each of said switches (14, 34, 28, 18, 46, 22, 50, 58, 68, 72) is a MOSFET.

6. A method of receiving a sampled input signal and producing a filtered output signal, comprising the following steps with n=1,2 ... and with m=1, 2, ..:

receiving a n-th input signal sample of an input signal ($V_{in}$),

charging it on an integration capacitor (64) to provide a m-th output signal sample whose magnitude is equal to the level of said n-th input signal sample,

simultaneously charging it on a charging capacitor (44), having a fractional capacitance of the capacitance of said integration capacitor,

discharging said integration capacitor,

integrating the charge stored on said charging capacitor from said n-th input signal sample on said integration capacitor,

receiving a (n+1)th input signal sample,

charging it on said charging capacitor,

integrating said charge stored on said charging capacitor from said (n+1)th input signal sample thereby providing a (m+1)th output signal sample whose magnitude lies between the levels of n-th and (n+1)th input signal samples,

discharging said integration capacitor and

repeating the steps with receiving at first said (n+1)th input signal sample, thus producing an output signal ($V_o$) which is sampled at twice the input signal sampling frequency.

**Patentansprüche**

1. Schaltungsanordnung (10) zum Empfang eines abgetasteten Eingangssignals und zur Erzeugung eines Ausgangssignals, mit

einem Eingangsanschluß zum Empfang des abgetasteten Eingangssignals,

einem Operationsverstärker (38) mit einem invertierenden Eingang, einem mit Erde verbundenen nicht-invertierenden Eingang und einem Ausgang,

einem einen geschalteten Kondensator aufweisenden Eingangsnetzwerk (14, 30, 34; 22, 44, 46), das zwischen dem invertierenden Eingang und dem Eingangsschluß angeschlossen ist und das einen ersten und einen zweiten Kondensator (30, 44) umfaßt, wobei der zweite Kondensator (44) eine vorgegebene Teilkapazität des ersten Kondensators (30) aufweist,

einer ersten Schaltereinrichtung (14, 34) die den ersten Kondensator (30) zwischen dem invertierenden Eingang und dem Eingangsanschluß anschließt,

einer zweiten Schaltereinrichtung (22, 46), die den zweiten Kondensator (44) zwischen dem invertierenden Eingang und dem Eingangsanschluß anschließt,

einem ersten Taktsignal (Ø1) und einem zweiten Taktsignal (Ø2) in Gegenphase zu dem ersten Taktsignal (Ø1) zur Steuerung der ersten und zweiten Schaltereinrichtung (14, 34; 22, 46) und

einer Rückkopplungseinrichtung (64, 68, 72, 78), die zwischen dem Ausgang und dem invertierenden Eingang angeschlossen ist, dadurch gekennzeichnet,

daß die Rückkopplungseinrichtung (64, 72, 78, 68) mit dem Eingangsnetzwerk derart zusammenwirkt, daß ein abgetastetes Ausgangssignal mit der doppelten Frequenz der Eingangssignal-Abtastfrequenz erzeugbar ist und daß jede zweite Ausgangssignalabtastung gleich ist dem Negativen der Eingangssignalabtastung ist und die jeweils andere Ausgangssignalabtastung gleich einem Wert ist, der aus den negativen Werten zweier benachbarter Eingangssignalabtastungen interpoliert ist.

2. Schaltungsanordnung nach Anspruch 1, gekennzeichnet durch

einen ersten Schalter (14), der durch das erste Taktsignal (Ø1) steuerbar ist und eine Seite des ersten Kondensators (30) mit dem Eingangsanschluß verbindet,

einen zweiten Schalter (34), der durch das erste Taktsignal (Ø1) steuerbar ist und die andere Seite des ersten Kondensators (30) mit dem invertierenden Eingang verbindet,

einen dritten Schalter (28), der durch das zweite Taktsignal (Ø2) steuerbar ist und die eine Seite des ersten Kondensators (30) mit Erde verbindet,

einen vierten Schalter (18), der durch das erste Taktsignal (Ø1) steuerbar ist und eine Seite des zweiten Kondensators (44) mit dem Eingangsanschluß verbindet,

einen fünften Schalter (46), der durch das zweite Taktsignal (Ø2) steuerbar ist und die eine Seite des zweiten Kondensators (44) mit dem invertierenden Eingang verbindet,

einen sechsten Schalter (22), der durch das zweite Taktsignal (Ø2) steuerbar ist und die andere Seite des zweiten Kondensators (44) mit dem Eingangsanschluß verbindet, und

einen siebten Schalter (50), der durch das erste Taktsignal (Ø1) steuerbar ist und die andere Seite des zweiten Kondensators (44) mit Erde verbindet.

3. Schaltungsanordnung nach Anspruch 1 oder 2, dadurch gekennzeichnet, daß die Rückkopplungseinrichtung aufweist:

einen dritten Kondensator (64), der zwischen dem invertierenden Eingung und dem Ausgangsanschluß angeschlossen ist,

einen achten Schalter (58), der durch das zweite Taktsignal (Ø2) steuerbar ist und die andere Seite des ersten Kondensators (30) mit dem Ausgangsanschluß verbindet,

einen vierten Kondensator (78), dessen eine Seite mit Erde verbunden ist,

einen neunten Schalter (68), der durch das erste Taktsignal (Ø1) steuerbar ist und die andere Seite des vierten Kondensators (78) mit dem Ausgangsanschluß verbindet, und

einen zehnten Schalter (72), der durch das zweite Taktsignal (Ø2) steuerbar ist und die andere Seite des vierten Kondensators (78) mit dem invertierenden Eingang verbindet.

4. Schaltungsanordnung nach einem der Ansprüche 1 bis 3, dadurch gekennzeichnet, daß der erste und ggfs. der dritte und der vierte Kondensator (14, 58, 78) eine Kapazität (C) aufweisen, die das Zweifache der Kapazität (0,5C) des zweiten Kondensators (44) ist.

5. Schaltungsanordnung nach einem der Ansprüche 1 bis 4, dadurch gekennzeichnet, daß jeder der Schalter (14, 34, 28, 18, 46, 22, 50, 58, 68, 72) ein MOSFET ist.

6. Verfahren zum Empfang eines abgetasteten Eingungssignals und zur Erzeugung eines gefilterten Ausgangssignals, umfassend folgende Schritte, mit n=1, 2 ... und m= 1, 2 ...

Empfangen einer n-ten Eingangssignalabtastung eines Eingangssignals (V$_{in}$),

deren Laden auf einen Integrationskondensator (64) zum Erzeugen einer m-ten Ausgangssignalabtastung, deren Größe gleich dem Pegel der n-ten Eingangssignalabtastung ist,

deren gleichzeitiges Laden auf einen Ladekondensator (44), der einen Bruchteil der Kapazität des Integrationskondensators besitzt,

Entladen des Integrationskondensators,

Integrieren der auf dem Ladekondensator gespeicherten Ladung von der n-ten Eingangssignalabtastung auf dem Integrationskondensator,

Empfangen einer (n+1)-ten Eingangssignalabtastung, deren Laden auf den Ladekondensator,

Integrieren der auf dem Ladekondensator gespeicherten Ladung von der (n+1)-ten Eingangssignalabtastung und dadurch Erzeugen einer (m+1)-ten Ausgangssignalabtastung, deren Größe zwischen den Pegeln der n-ten und (n+1)-ten Einganganssignalabtastung liegt,

Entladen des Integrationskondensators und Wiederholen der Schritte mit dem zunächst erfolgenden Empfang der (n+1)-ten Eingangssignalabtastung, wodurch ein Ausgangssignal (V$_o$) erzeugt wird, das mit dem Zweifachen der Eingangssignal-Abtastfrequenz abgetastet ist.

**Revendications**

1. Circuit pour la réception d'un signal d'entrée echantillonné et la production d'un signal de sortie, ce circuit (10) comprenant une borne d'entrée pour la réception dudit signal d'entrée échantillonné, un amplicateur opérationnel (38) ayant une entrée d'inversion, une entrée de non inversion reliée à la terre et une sortie, un réseau d'entrée à condensateurs commutés (14, 30, 34; 22, 44, 46) branché entre ladite entrée d'inversion et ladite borne d'entrée, ce réseau comprenant un premier et un deuxième condensateurs (30, 44), ce deuxième condensateur (44) ayant une capacité qui est une fraction prédéterminée de la capacité du premier condensateur (30), des premiers moyens de commutation (14, 34) raccordant le premier condensateur (30) entre l'entrée d'inversion et la borne d'entrée, des deuxièmes moyens de commutation (22, 46) raccordant le deuxième condensateur (44) entre l'entrée d'inversion et la borne d'entrée, une première horloge (Ø1) et une deuxième horloge (Ø2) en opposition de phase avec la première horloge (Ø1) pour commander les premiers et deuxiemes moyens de commutation (14, 34; 22, 46), et des moyens de réaction (64, 68, 72, 78) branchés entre ladite sortie et l'entrée d'inversion, ledit circuit (10) étant caractérisé en ce que:

les moyens de réaction (64, 72, 78, 68) coopèrant avec ledit réseau d'entrée pour fournir un signal de sortie échantillonné à une fréquence double de la fréquence d'échantillonnage du signal d'entrée et chaque deuxième échantillon de signal de sortie est égal à la valeur négative de l'échantillon de signal d'entrée, et chaque autre échantillon de signal de sortie est égal à une valeur interpolée à partir des valeurs négatives de deux échantillons adjacents de signal d'entrée.

2. Circuit suivant la revendication 1, caractérisé en ce qu'il comprend:

un premier commutateur (14) commandé par la première horloge (Ø1) et reliant un premier côté du premier condensateur (30) à la borne d'entrée,

un deuxième commutateur (34) commandé par la première horloge (Ø1) et reliant l'autre côté du premier condensateur (30) à l'entrée d'inversion,

un troisième commutateur (28) commandé par la deuxième horloge (Ø2) et reliant ledit premier côté du premier condensateur (30) à la terre,

un quatrième commutateur (18) commandé par la première horloge (Ø1) et reliant un premier côté du deuxième condensateur (44) à la borne d'entrée,

un cinquième commutateur (46) commandé par la deuxième horloge (Ø2) et reliant ledit premier côté du deuxième condensateur (44) à l'entrée d'inversion,

un sixième commutateur (22) commandé par la deuxième horloge (Ø2) et reliant l'autre côté du deuxième condensateur (44) à la borne d'entrée, et

un septième commutateur (50) commandé par la première horloge (Ø1) et reliant ledit autre côté du deuxième condensateur (44) à la terre.

3. Circuit suivant la revendication 1 ou 2, caractérisée en ce que lesdits moyens de réaction comprennent:

un troisième condensateur (64) branché entre l'entrée d'inversion et la borne de sortie,

un huitième commutateur (58) commandé par la deuxième horloge (Ø2) et reliant l'autre côté du premier condensateur (30) et ladite sortie,

un quatrième condensateur (78) dont un premier côté est relié à la terre,

un neuvième commutateur (68) commandé par la première horloge (Ø1) et reliant l'autre côté du quatrième condensateur (78) avec ladite sortie, un dixième commutateur (72) commandé par la deuxième horloge (Ø2) et reliant l'autre côté du quatrième condensateur (78) avec l'entrée d'inversion.

4. Circuit suivant l'une quelconque des revendications 1 à 4, caractérisé en ce que le premier et, le cas echéant, les troisième et quatrième condensateur(s) (14, 58, 78) est/sont de la même capacité (C) qui est le double de la capacité (0,5 C) du deuxième condensateur (44).

5. Circuit suivant l'une quelconque des revendications 1 à 4, caractérisé en ce que chacun des commutateurs (14, 34, 28, 18, 46, 22, 50, 58, 68, 72) est un transistor de type MOSFET.

6. Procédé de réception d'un signal d'entrée échantillonné et de production d'un signal de sortie filtré, comprenant les opérations suivantes, avec n=1, 2... et avec m=1, 2...;

— réception d'un $n^{ième}$ échantillon de signal d'entrée d'un signal d'entrée ($V_{in}$),
— charge de cet échantillon sur un condensateur d'intégration (64) pour fournir un $m^{ième}$ échantillon de signal de sortie dont la grandeur est égale au niveau dudit $n^{ième}$ échantillon de signal d'entrée,
— simultanément, charge de l'échantillon de signal d'entrée sur un condensateur de charge (44) dont la capacité est une fraction de la capacité du condensateur d'intégration,
— décharge du condensateur d'intégration,
— intégration de la charge stockée sur le condensateur de charge, provenant dudit $n^{ième}$ échantillon de signal d'entrée, sur le condensateur d'intégration,
— réception d'un $(n+1)^{ième}$ échantillon de signal d'entrée,
— charge de cet échantillon sur le condensateur de charge,
— intégration de la charge stockée sur le condensateur de charge et provenant dudit $(n+1)^{ième}$ échantillon de signal d'entrée, de manière à fournir un $(m+1)^{ième}$ échantillon de signal de sortie dont la grandeur ist comprise entre les niveau des $n^{ième}$ et $(n+1)^{ième}$ échantillons de signal d'entrée,
— décharge du condensateur d'intégration et
— répétition des opérations avec réception en premier lieu dudit $(n+1)^{ième}$ échantillon de signal d'entrée, de façon à produire un signal de sortie ($V_o$) qui est échantillonné à une fréquence double de la fréquence d'échantillonnage du signal d'entrée.

0 054 561

$\phi_2$
60
58
64
56
$\phi_1$ 24 C 12
$V_{IN}$ 14 36 62
30 32 34 52 54
$\phi_2$ 74 $V_O$
26 38
28 66
$\phi_1$ $\phi_2$ $\phi_2$ $\phi_1$
16 40 70
18 46 48 72 76 68
$\phi_2$ 5C $\phi_1$ 78 C
44
10 20 22 42 50

FIG.1

FIG.1A

$\phi_1$

$\phi_2$

$V_0/V_{in}$

INPUT TO INTERPOLATION
80
OUTPUT OF INTERPOLATION
82

$V_{in}(nT)$
$V_{in}(nT-T)$
$\dfrac{V_{in}(nT-T)+V_{in}(nT)}{2}$

nT

$nT-\dfrac{T}{2}$  nT  $nT+\dfrac{T}{2}$

FIG.2